# EUROPEAN PATENT SPECIFICATION

(11) **EP 1 911 102 B1**
(45) Date of publication and mention of the grant of the patent: **26.09.2012**
(21) Application number: 06783861.5
(22) Date of filing: 28.07.2006
(51) Int. Cl.: H01L 31/18, H01L 21/316, H01L 21/3105, C23C 16/40, C23C 16/56, C23C 16/513

(54) **METHOD FOR PASSIVATING A SUBSTRATE SURFACE**
VERFAHREN ZUM PASSIVIEREN EINER SUBSTRATOBERFLÄCHE
PROCEDE DE PASSIVATION DE LA SURFACE D'UN SUBSTRAT

(30) Priority: 29.07.2005 NL 1029647
(43) Date of publication of application: 16.04.2008
(73) Proprietor: OTB Solar B.V., 5657 EB Eindhoven (NL)
(72) Inventor: BIJKER, Martin Dinant, NL-5709 KR Helmond (NL); HOEX, Bram, NL-5014 KX Tilburg (NL); KESSELS, Wilhelmus Mathijs Marie, NL-5045 ZZ Tilburg (NL); VAN DE SANDEN, Mauritius Cornelis Maria, NL-5017 JH Tilburg (NL)
(74) Representative: Hatzmann, Martin
(86) International application number: PCT/NL2006/000393
(87) International publication number: WO 2007/013806

(56) References cited:
- US-A- 4 253 881
- US-A- 5 462 898
- LEGUIJT C ET AL: "Low temperature surface passivation for silicon solar cells" SOLAR ENERGY MATERIALS AND SOLAR CELLS, ELSEVIER SCIENCE PUBLISHERS, AMSTERDAM, NL, vol. 40, no. 4, 1 August 1996 (1996-08-01), pages 297-345, XP004008111 ISSN: 0927-0248
- CHEN Z ET AL: "SILICON SURFACE AND BULK DEFECT PASSIVATION BY LOW TEMPERATURE PECVD OXIDES AND NITRIDES" WORLD CONFERENCE ON PHOTOVOLTAIC ENERGY. WAIKOLOA, DEC. 5 - 9, 1994, NEW YORK, IEEE, US, vol. VOL. 2 CONF. 1, 5 December 1994 (1994-12-05), pages 1331-1334, XP000680085 ISBN: 0-7803-1460-3
- VERMEULEN T ET AL: "Interaction between bulk and surface passivation mechanisms in thin film solar cells on defected silicon substrates" PROC. OF THE 25TH PVSC CONFERENCE, MAY 13-17 1996, WASHINGTON D.C., USA, IEEE, 13 May 1996 (1996-05-13), pages 653-656, XP010208236
- ELGAMEL H E ET AL: "EFFICIENT COMBINATION OF SURFACE AND BULK PASSIVATION SCHEMES OF HIGH-EFFICIENCY MULTICRYSTALLINE SILICON SOLAR CELLS" JOURNAL OF APPLIED PHYSICS, AMERICAN INSTITUTE OF PHYSICS. NEW YORK, US, vol. 78, no. 5, 1 September 1995 (1995-09-01), pages 3457-3461, XP000541608 ISSN: 0021-8979
- ROHATGI A ET AL: "COMPREHENSIVE STUDY OF RAPID, LOW-COST SILICON SURFACE PASSIVATION TECHNOLOGIES" IEEE TRANSACTIONS ON ELECTRON DEVICES, IEEE SERVICE CENTER, PISACATAWAY, NJ, US, vol. 47, no. 5, May 2000 (2000-05), pages 987-993, XP000928620 ISSN: 0018-9383
- NAGAYOSHI H ET AL: "The stability of SiNx:H/SiO2 double-layer passivation with Hydrogen-radical annealing" PROCEEDINGS OF THE EUROPEAN PHOTOVOLTAIC SOLAR ENERGY CONFERENCE, vol. 1, 30 June 1997 (1997-06-30), pages 739-742, XP002160392

## Description

The invention relates to a method for passivating at least a part of a surface of a semiconductor substrate.

Such a method is known from practice. In the known method, a substrate surface of a semiconductor substrate is passivated by realizing a SiOₓ layer, for instance a layer of silicon oxide, on that surface. Here, for instance, use can be made of an oxidation method in an oven. Another known method comprises sputtering the SiOₓ layer. Further, it is known from practice to deposit silicon oxide on a substrate by means of chemical vapor deposition.

The extent of surface passivation is usually expressed by the surface recombination velocity (SRV). A good surface passivation of the semiconductor substrate usually means a relatively low surface recombination velocity.

From the article "Plasma-enhanced chemical-vapor-deposited oxide for low surface recombination velocity and high effective lifetime in silicon", Chen et al, Journal of Applied Physics 74(4), August 15, 1993, pp. 2856-2859, a method is known in which a low SRV (< 2 cm/s) can be obtained with virtually intrinsic silicon substrates, which have relatively high resistivities (> 500 Ωcm). In this known method, use is made of a direct plasma enhanced chemical-vapor deposition (PECVD) and a subsequent thermal anneal in a forming gas at preferably 350°C.

The publication "low temperature surface passivation for silicon solar cells" of Leguijt et al., Solar Energy Materials And Solar Cells vol. 40, no. 4, 1 August 1996, pages 297-345, discloses a low temperature surface passivation for silicon solar cells. The method involves PECVD as a method to achieve surface passivation at low temperatures.

Publication US-A-5 462 898 discloses a method for passivating silicon devices at low temperature, involving PECVD as well.

Up to now, it has still been found a problem to properly passivate a substrate with a relatively low resistivity, at least such that a relatively low surface recombination velocity can be reached, in particular using deposition of a SiOₓ layer. Such a passivated semiconductor substrate is, for instance, desired for the manufacture of solar cells.

The present invention contemplates obviating above-mentioned drawbacks of the known method. In particular, the invention contemplates a method for passivating a semiconductor substrate, in which a SiOₓ layer obtained with the method has a relatively low surface recombination velocity, while the substrate particularly has a relatively low resistivity.

To this end, the method according to the invention is characterized by the features of claim 1 and *of* claim 2.

It is found that, in this manner, a good surface passivation of the substrate, at least of above-mentioned part of the substrate surface, can be obtained, in particular when the semiconductor substrate inherently has a relatively low resistivity.

According to an embodiment, the anneal treatment comprises a temperature treatment in a gas environment, the temperature treatment including maintaining the SiOₓ layer at a treatment temperature in the range of 250°C-1000°C.

Preferably, during above-mentioned temperature treatment, at least above-mentioned SiOₓ layer realized on the substrate is maintained at a treatment temperature which is higher than 350°C. It is found that, with such a temperature treatment, particularly good results can be obtained. The treatment temperature is in the range of 250°C-1000°C, in particular in the range of 500°C-700°C, more in particular in the range of 550°C-650°C. The temperature treatment may, for instance, take less than 20 min.

After that temperature treatment, the substrate may, for instance, be cooled, optionally in a forced manner. In addition, preferably, a gas flow is supplied to above-mentioned substrate or at least the SiOₓ layer realized and the substrate during above-mentioned temperature treatment, to provide above-mentioned gas environment. Thus, the temperature treatment may, for instance, comprise a forming gas anneal treatment. The gas environment may, for instance, be provided by supplying a mixture of nitrogen and hydrogen to the substrate and/or the at least one layer realized on the substrate. In that case, the gas environment may, for instance, comprise a hydrogen-nitrogen environment. On the other hand, the gas environment may, for instance, substantially comprise hydrogen gas, for instance by supplying a hydrogen gas flow to the substrate and/or the at least one layer realized on the substrate. The gas or gas mixture then preferably has the same above-mentioned substrate treatment temperature.

According to one aspect of the invention according to claim 2, after the at least one layer has been realized on the substrate, H₂ or a mixture of H₂ with an inert gas, for instance N₂ or Ar, is supplied to above-mentioned plasma, in particular for annealing the at least one layer and/or for increasing the diffusion of H₂ in the at least one layer.

A solar cell, which is provided with at least a part of a substrate at least obtained with a method according to the invention, can use improved properties in an advantageous manner, for instance a relatively low surface recombination velocity of the substrate surface, which is favorable to the performance of the solar cell.

Further elaborations of the invention are described in the subclaims. The invention will now be elucidated on the basis of a non-limitative exemplary embodiment and with reference to the drawing, in which:
Fig. 1 shows a schematic cross-sectional view of an apparatus for treating a substrate; and
Fig. 2 shows a detail of the cross-sectional view shown in Fig. 1, in which the plasma cascade source is shown.

In this patent application, same or corresponding measures are designated by same or corresponding reference symbols. In the present application, a value provided with a term like "approximately", "substantially", "about" or a similar term can be understood as being in a range between that value minus 5% of that value on the one hand and that value plus 5% of that value on the other hand.

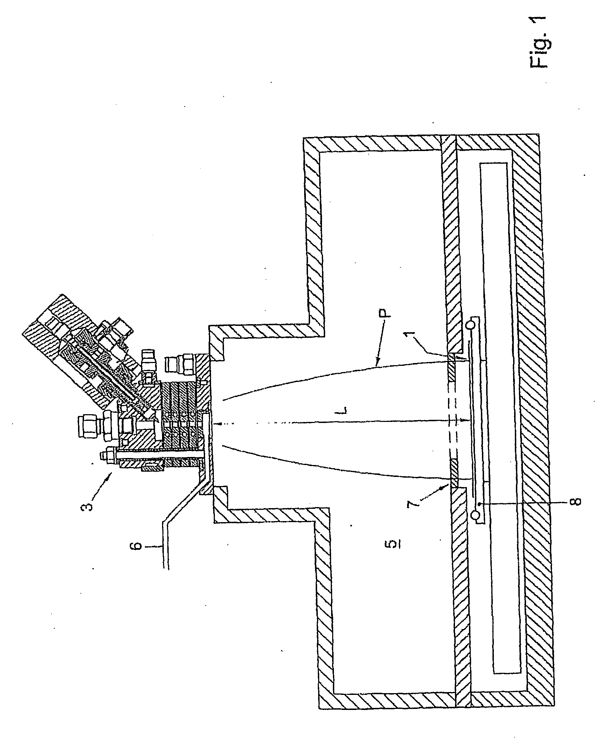

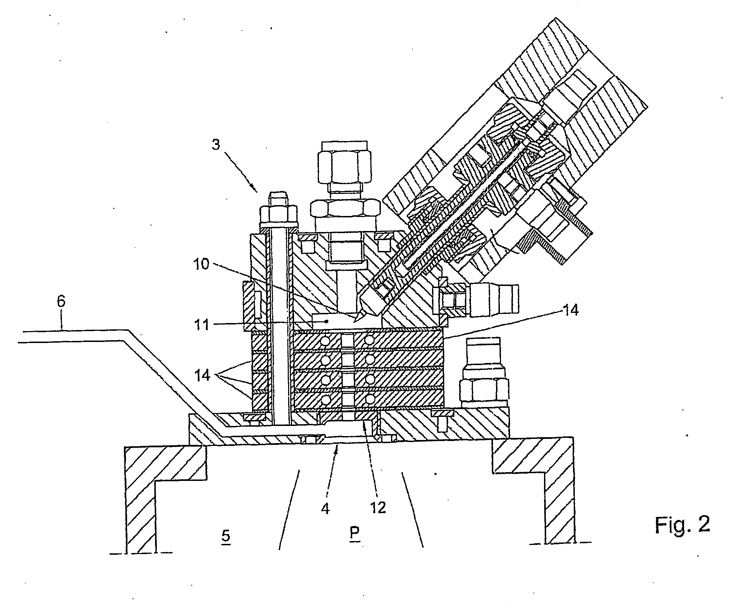

Figs. 1 and 2 show an apparatus with which at least a deposition or realization of at least one SiOₓ layer, and for instance one or more other layers on a substrate can be carried out, in a method according to the invention. The apparatus is, for instance, well suitable for use in an inline process. The apparatus shown in Figs. 1 and 2 is provided with a process chamber 5 on which a DC (direct current) plasma cascade source 3 is provided. Alternatively, a different type of plasma source may be used. The DC plasma cascade source 3 of the exemplary embodiment is arranged for generating a plasma with DC voltage. The apparatus is provided with a substrate holder 8 for holding one substrate 1 opposite an outflow opening 4 of the plasma source 3 in the process chamber 5. The apparatus further comprises heating means (not shown) for heating the substrate 1 during the treatment.

As shown in Fig. 2, the plasma cascade source 3 is provided with a cathode 10 located in a front chamber 11 and an anode 12 located at a side of the source 3 proximal to the process chamber 5. The front chamber 11 opens into the process chamber 5 via a relatively narrow channel 13 and the above-mentioned plasma outflow opening 4. The apparatus is, for instance, dimensioned such that the distance L between the substrate 1 and the plasma outflow opening 4 is approximately 200 mm - 300 mm. Thus, the apparatus can have a relatively compact design. The channel 13 can be bounded by mutually electrically insulated cascade plates 14 and the above-mentioned anode 12. During treatment of a substrate, the process chamber 5 is kept at a relatively low pressure, lower than 5000 Pa, and preferably lower than 500 Pa. Of course, *inter alia* the treatment pressure and the dimensions of the process chamber need to be such that the growth process can still take place. In practice, with a process chamber of the present exemplary embodiment, the treatment pressure is found to be at least approximately 0.1 mbar for this purpose. The pumping means needed to obtain the above-mentioned treatment pressure are not shown in the drawing. Between the cathode 10 and anode 12 of the source 3, a plasma is generated during use, for instance by ignition of an inert gas, such as argon, which is present therebetween. When the plasma has been generated in the source 3, the pressure in the front chamber 11 is higher than the pressure in the process chamber 5. This pressure can, for instance, be substantially atmospheric and be in the range of 0.5-1.5 bar. Because the pressure in the process chamber 5 is considerably lower than the pressure in the front chamber 11, a part of the generated plasma P expands such that it extends via the relatively narrow channel 7 from the above-mentioned outflow opening 4 into the process chamber 5 for contacting the surface of the substrate 1. The expanding plasma part may, for instance, reach a supersonic velocity.

The apparatus is particularly provided with supply means 6, 7 for supplying flows of suitable treatment fluids to the plasma P in, for instance, the anode plate 12 of the source 3 and/or in the process chamber 5. Such supply means may in themselves be designed in different manners, which will be clear to a skilled person. In the exemplary embodiment, the supply means comprise, for instance, an injector 6 designed for introducing one or more treatment fluids into the plasma P near the plasma source 3. The supply means further comprise, for instance, a shower head 7 for supplying one or more treatment fluids to the plasma P downstream of the above-mentioned plasma outflow opening 4 near the substrate 1. Alternatively, such a shower head 7 is, for instance, arranged near or below the plasma source 3 in the process chamber 5. The apparatus is provided with sources (not shown) which are connected to the above-mentioned supply means 6, 7 via flow control means, for supplying specific desired treatment fluids thereto. In the exemplary embodiment, during use, preferably no reactive gases, such as silane, hydrogen and/or oxygen, are supplied to the plasma in the plasma source 3, so that the source 3 cannot be affected by such gases.

For the purpose of passivating the substrate 1, during use, the cascade source 3 generates a plasma P in the described manner, such that the plasma P contacts the substrate surface of the substrate 1. Flows of treatment fluids suitable for SiOₓ deposition are supplied to the plasma P in a suitable ratio via the supply means 6, 7. The process parameters of the plasma treatment process, at least the above-mentioned process chamber pressure, the substrate temperature, the distance L between the plasma source 3 and the substrate 1, and the flow rates of the treatment fluids are preferably such that the apparatus deposits the SiOₓ layer on the substrate 1 at an advantageous velocity which is, for instance, in the range of 1-15 nm/s, which, for instance, depends on the velocity of the apparatus.

The above-mentioned substrate temperature, at least during the deposition of SiOx, may, for instance, be in the range of 250-550°C, more in particular in the range of 380-420°C.

Above-mentioned treatment fluids may comprise various precursors suitable for SiOx deposition. Thus, for instance, D4 and O₂ can be supplied to above-mentioned part of the plasma P, for depositing a SiOₓ layer on the substrate surface, which is found to yield good results. The D4 (also known as octamethyltetrasiloxane) may, for instance, be liquid, and, for instance, be supplied to the plasma via above-mentioned shower head 7. The O₂ may, for instance, be gaseous and be supplied to the plasma via above-mentioned injector 6.

Further, at least one precursor may, for instance, be selected from the group consisting of: SiH₄, O₂, NO₂, CH₃SiH₃ (1MS), 2(CH₃)SiH₂ (2MS), 3(CH₃)SiH (3MS), siloxanes, hexamethylsiloxane, octamethyltrisiloxane (OMTS), bis(trimethylsiloxy)methylsilane (BTMS), octamethyltetrasiloxane (OMCTS, D4) and TEOS. The precursor may further comprise one or more other substances suitable for SiOₓ.

Since the plasma cascade source operates with DC voltage for generating the plasma, the SiOₓ layer can simply be grown at a constant growth rate, substantially without adjustment during deposition. This is advantageous compared to use of a plasma source driven with AC. Further, with a DC plasma cascade source, a relatively high growth rate can be obtained. It is found that, with this apparatus, a particularly good surface-passivated substrate can be obtained, in particular with a SiOₓ layer, with a relatively low substrate resistivity.

Optionally, on above-mentioned SiOₓ layer, for instance, a SiNₓ may be provided, which may, for instance, form an anti-reflection coating. Further, such a SiNₓ layer may, for instance, supply hydrogen to the deposited SiOₓ layer for the purpose of passivation of the substrate. Preferably, the SiOₓ layer and SiNₓ layer are successively deposited on the substrate 1 by the same deposition apparatus. To this end, for instance, precursors suitable for SiNₓ deposition (for instance NH₃, SiH₄, N₂, and/or other precursors) can be supplied to the plasma P via above-mentioned supply means 6, 7 after deposition of the SiOₓ, layer. The layer stack comprising at least one SiOₓ layer and at least one SiNₓ layer is also called a SiOₓ/SiNₓ stack. The thickness of above-mentioned SiNₓ layer is preferably in the range of 25 to 100 nm, and may, for instance, be 80 nm.

Further, for instance, an apparatus may be provided for subjecting the substrate to a temperature treatment after deposition of one or more of above-mentioned layers, for instance to a forming gas anneal treatment in which suitable gases are supplied to the substrate. In this manner, the temperature treatment can be carried out in a gas environment, at least such that at least one surface of the at least one layer realized on the substrate is contacted with those gases. A gas mixture suitable for the temperature treatment is, for instance, a hydrogen-nitrogen mixture. Such a temperature treatment may, for instance, be carried out in a separate thermal treatment apparatus, a separate forming gas anneal apparatus, or the like.

Further, during use of the apparatus, for instance H₂ or a mixture of H₂ and an inert gas such as N₂ or Ar may be supplied to a plasma P, after the at least one layer has been realized on the substrate, for instance for increasing the diffusion of H₂ in the SiOₓ layer or the SiOₓ/SiNₓ stack. Such a plasma treatment may, for instance, be carried out instead of the above-mentioned temperature treatment or in combination with such a temperature treatment.

### Example

A silicon oxide (SiO) layer was deposited on a substrate surface of a monocrystalline silicon with a method according to the invention, using an above-described apparatus shown in the Figures. The layer thickness was approximately 100 nm. The substrate inherently had a relatively low resistivity, for instance a resistivity of less than approximately 10 Ωcm. In particular, use was made of an n-doped silicon wafer with a resistivity of 1.4 Ωcm.

In order to deposit the above-mentioned silicon oxide layer on the substrate surface, in this example, use was made of flows of the precursors D4 and O₂. Here, for instance, a D4 flow rate of approximately 5-10 grams per hour was used and a O₂ flow rate of approximately 200 sccm (standard cm⁻³ per minute). The deposition treatment temperature of the substrate was, during the SiOₓ deposition, approximately 400°0.

The deposited silicon oxide layer was optionally provided with a SiNₓ layer, using N₂H₃ and SiH₄, for forming a SiOₓ/SiNₓ stack on the substrate. The SiNₓ layer may, for instance, supply hydrogen to the deposited SiOₓ layer, and also serve as an anti-reflection layer.

After the deposition of above-mentioned layer/layers, the substrate was subjected to a temperature treatment, for instance using a suitable forming gas anneal apparatus. During this temperature treatment, the deposited SiOₓ layer and/or SiNₓ layer was maintained at a treatment temperature of approximately 600°C for a treatment period of approximately 15 min, and in particular at an atmospheric pressure. In addition, during the temperature treatment, a 90% N₂ - 10% H₂ gas mixture was supplied to a surface of the SiOₓ layer and/or the SiOₓ/SiNₓ stack for obtaining a forming gas anneal. After above-mentioned approximately 15 min, the substrate and the at least one layer provided thereon were cooled.

The SiOₓ layer or SiOₓ/SiN₂ stack thus obtained was found to have a stable, particularly low surface recombination velocity of approximately 50 cm/s. Therefore, the substrate treated in this manner, which has a very low resistivity, is particularly well suitable for use as, for instance, a 'building block' of solar cells.

It goes without saying that various modifications are possible.

Thus, substrates of various semiconductor materials can be used to be passivated by the method according to the invention.

In addition, the method may, for instance, be carried out using more than one plasma source mounted on a process chamber.

Further, the substrate may, for instance, be loaded into the process chamber 5 from a vacuum environment, such as a load lock brought to a vacuum and mounted to the process chamber. In that case, the pressure in the process chamber 5 can maintain a desired low value during loading. In addition, the substrate may, for instance, be introduced into the process chamber 5 when that chamber 5 is at an atmospheric pressure, while the chamber 5 is then closed and pumped to the desired pressure by the pumping means.

In addition, the plasma source may, for instance, generate a plasma which exclusively contains argon.

Further, for instance, one or more layers can be applied to the substrate, for instance one or more SiOₓ layers and one or more optional other layers such as for instance SiNₓ layers.

Further, preferably, a whole surface of a substrate is passivated by means of a method according to the invention. Alternatively, for instance, only a part of the surface may be passivated by means of the method.

Further, the thickness of the SiOₓ layer realized on the substrate by means of the plasma treatment process may, for instance, be in the range of 10-1000 nm.

Further, a plasma with O₂ as a precursor may, for instance, modify a substrate surface of the substrate, or part of the surface, into SiOₓ, so that above-mentioned SiOₓ layer is realized. In that case, the SiOₓ layer is, in particular, not realized by means of deposition, but by means of modification. The SiOₓ layer may also be realized in a different manner, however still according to the terms of claims 1 ou 2.

## Claims

1. A method for passivating at least a part of a surface of a semiconductor substrate, wherein at least one layer comprising at least one SiOₓ layer is realized on said part of the substrate surface by:
- providing an apparatus with a process chamber (5);
- placing a substrate (1) in the process chamber (5);
- maintaining the substrate (1) at a specific substrate treatment temperature suitable for realizing said layer;
- generating a plasma (P);
- contacting at least a part of the plasma (P) with the said part of the substrate surface;
- supplying at least one precursor suitable for SiOₓ realization to the said part of the plasma (P);
- realizing said layer;
wherein after the at least one layer has been realized, the layer is subjected to a temperature treatment in a gas environment for annealing the layer, wherein the temperature treatment particularly comprises a forming gas anneal treatment;
**the method being characterized in that:**
the step of providing an apparatus is performed by providing an apparatus with a process chamber (5) on which at least one plasma cascade source (3) is provided, wherein in each plasma cascade source, a DC voltage is used for generating the plasma, the apparatus being further provided with an injector (6) designed for introducing one or more treatment fluids into the plasma (P) near the plasma source (3);
- the step of placing the substrate is performed by placing the substrate (1) opposite to an outflow opening (4) of the plasma cascade source (3) in the process chamber (5);
the step of generating a plasma (P) is performed by means of the at least one plasma cascade source (3) mounted on the process chamber (5) at a specific distance (L) from the substrate surface;
wherein at least a part of the plasma (P) generated by each source (3) is contacted with the said part of the substrate surface;
wherein the pressure in the process chamber (5) is maintained at a pressure lower than 5000 Pa, wherein the pressure in the process chamber is lower than the pressure in a front chamber (11) of the source, so that a part of the generated plasma (P) expands such that it extends from an outflow opening (4) of the source (3) into the process chamber (5) and contacts the surface of the substrate (1).

2. A method for passivating at least a part of a surface of a semiconductor substrate, wherein at least one layer comprising at least one SiOₓ layer is realized on said part of the substrate surface by:
- providing an apparatus with a process chamber (5);
- placing a substrate (1) in the process chamber (5);
- maintaining the substrate (1) at a specific substrate treatment temperature suitable for realizing said layer;
- generating a plasma (P);
- contacting at least a part of the plasma (P) with the said part of the substrate surface;
- supplying at least one precursor suitable for SiOₓ realization to the said part of the plasma (P);
- realizing said layer;
wherein after the at least one layer has been realized, the layer is subjected to an anneal treatment for annealing the layer;
**the method being characterized in that:**
the step of providing an apparatus is performed by providing an apparatus with a process chamber (5) on which at least one plasma cascade source (3) is provided, wherein in each plasma cascade source, a DC voltage is used for generating the plasma, the apparatus being further provided with an injector (6) designed for introducing one or more treatment fluids into the plasma (P) near the plasma source (3);
- the step of placing the substrate is performed by placing the substrate (1) opposite to an outflow opening (4) of the plasma cascade source (3) in the process chamber (5);
the step of generating a plasma (P) is performed by means of the at least one plasma cascade source (3) mounted on the process chamber (5) at a specific distance (L) from the substrate surface;
wherein at least a part of the plasma (P) generated by each source (3) is contacted with the said part of the substrate surface;
wherein the pressure in the process chamber (5) is maintained at a pressure lower than 5000 Pa, wherein the pressure in the process chamber is lower than the pressure in a front chamber (11) of the source, so that a part of the generated plasma (P) expands such that it extends from an outflow opening (4) of the source (3) into the process chamber (5) and contacts the surface of the substrate (1),
wherein the anneal treatment includes supplying H₂ or a mixture of H₂ and an inert gas such as N₂ or Ar to a plasma.

3. The method according to claim 1 or 2, wherein the anneal treatment comprises a temperature treatment in a gas environment, the temperature treatment including maintaining the SiOₓ layer at a treatment temperature in the range of 250°C-1000°C.

4. A method according to claim 3, wherein said treatment temperature is in the range of 500°C-700°C, more in particular in the range of 550°C-650°C, for instance 600°C.

5. A method according to claim 3 or 4, wherein said temperature treatment takes less than 20 min.

6. A method according to any one of claims 3-5, wherein, during said temperature treatment, a gas flow is supplied to said substrate (1) or at least the at least one layer realized on the substrate (1) for providing said gas environment.

7. A method according to any one of claims 3-6, wherein said gas environment comprises a mixture of nitrogen gas and hydrogen gas.

8. A method according to claim 7, wherein the ratio of nitrogen:hydrogen in said mixture is in the range of 75:25 to 99: 1, in particular in the range of 85:15 to 95:5, and is for instance 90: 10.

9. A method according to any one of claims 3-6, wherein said gas environment comprises hydrogen gas, by supplying a hydrogen gas flow to the substrate and/or the at least one layer realized on the substrate.

10. A method according to any one of the preceding claims, wherein the method includes selecting at least one precursor, suitable for SiOₓ realization, from the group consisting of:
-SiH₄
-O₂;
- NO₂
-CH₃SiH₃ (1MS);
-2(CH₃)SiH₂ (2MS);
-3(CH₃)SiH (3MS);
-siloxanes
-hexamethylsiloxane;
-octamethyltrisiloxane;
-bis(trimethylsiloxy)methylsilane;
-octamethyltetrasiloxane (D4); and
-tetraethyl orthosilicate (TEOS).

11. A method according to any one of the preceding claims, wherein the substrate (1) inherently has a relatively low resistivity, of less than 10Ωcm, in particular a resistivity of 2 Ωcm or lower.

12. A method according to any one of the preceding claims, **characterized in that** the SiOₓ layer is deposited on the substrate (1) at a growth rate which is in the range of 1-15 nm/s.

13. A method according to any one of the preceding claims, **characterized in that** the said treatment temperature of the substrate is, at least during the realization of SiOₓ, in the range of 250-550°C, more in particular in the range of 380-420°C.

14. A method according to any one of the preceding claims, **characterized in that** the thickness of the SiOₓ layer realized on the substrate (1) by means of the plasma treatment process is in the range of 10-1000 nm.

15. A method according to any one of the preceding claims, wherein the at least one layer is further provided with at least one SiNₓ layer, wherein the SiNₓ layer is, for instance, realized on said SiOₓ layer, for instance for supplying hydrogen to the deposited SiOₓ layer for the purpose of passivating the substrate.

16. A method according to claim 15, wherein said SiOₓ layer and SiNₓ layer are successively provided on the substrate (1) by the same apparatus.

17. A method according to claim 15 or 16, wherein the thickness of said SiNₓ layer is in the range of 25 to 100 nm, and is in particular 80 nm.

18. A method according to any one of the preceding claims, wherein the plasma is provided with O₂ as a precursor, such that said substrate surface is modified into SiOₓ for realizing said SiOₓ layer.

19. A method according to claim 1,
wherein the anneal treatment comprises supplying H₂ or a mixture of H₂ and an inert gas, for instance N₂ or Ar, to said plasma.

20. A method according to any of the preceding claims, wherein the expanding plasma part reaches a supersonic velocity.

## Patentansprüche

1. Verfahren zum Passivieren von mindestens einem Teil einer Oberfläche eines Halbleitersubstrats, wobei mindestens eine Schicht, umfassend mindestens eine SiOₓ-Schicht, auf dem Teil der Substratoberfläche hergestellt wird durch:
- Bereitstellen einer Vorrichtung mit einer Prozesskammer (5);
- Platzieren eines Substrats (1) in die Prozesskammer (5);
- Aufrechterhalten des Substrats (1) bei einer bestimmten Substratbehandlungstemperatur, die geeignet ist, um die Schicht zu herzustellen;
- Erzeugen eines Plasmas (P);
- Inberührungbringen von mindestens einem Teil des Plasmas (P) mit dem Teil der Substratoberfläche;
- Zuführen von mindestens einem Vorläufer, geeignet für die SiOₓ-Herstellung zu dem Teil des Plasmas (P);
- Herstellen der Schicht;
wobei, nachdem die mindestens eine Schicht hergestellt wurde, die Schicht einer Temperaturbehandlung in einer Gasumgebung ausgesetzt wird, um die Schicht zu tempern, wobei die Temperaturbehandlung insbesondere eine Formiergastemperbehandlung umfasst;
**dadurch gekennzeichnet, dass**:
der Schritt der Bereitstellung einer Vorrichtung durch Bereitstellen einer Vorrichtung mit einer Prozesskammer (5), auf welcher mindestens eine Plasmakaskadenquelle (3) bereitgestellt ist, erfolgt, wobei in jeder Plasmakaskadenquelle eine Gleichstromspannung zum Erzeugen des Plasmas verwendet wird, die Vorrichtung ferner mit einem Injektor (6) versehen ist, der konzipiert ist, um ein oder mehrere Behandlungsfluide dem Plasma (P) nahe der Plasmaquelle (3) zuzuführen;
- der Schritt des Platzierens des Substrats ausgeführt wird, indem das Substrat (1) gegenüber einer Ausflussöffnung (4) der Plasmakaskadenquelle (3) in die Prozesskammer (5) platziert wird;
der Schritt des Erzeugens eines Plasmas (P) mithilfe der mindestens einen Plasmakaskadenquelle (3), angebracht auf der Prozesskammer (5) in einem bestimmten Abstand (L) von der Substratoberfläche, ausgeführt wird;
wobei mindestens ein Teil des von jeder Quelle (3) erzeugten Plasmas (P) mit dem Teil der Substratoberfläche in Berührung gebracht wird;
wobei der Druck in der Prozesskammer (5) auf einem Druck unter 5000 Pa gehalten wird, wobei der Druck in der Prozesskammer niedriger ist als der Druck in einer vorderen Kammer (11) der Quelle, sodass ein Teil des erzeugten Plasmas (P) so expandiert, dass es sich von einer Ausflussöffnung (4) der Quelle (3) in die Prozesskammer (5) erstreckt und die Oberfläche des Substrats (1) berührt.

2. Verfahren zum Passivieren von mindestens einem Teil einer Oberfläche eines Halbleitersubstrats, wobei mindestens eine Schicht, umfassend mindestens eine SiOₓ-Schicht, auf dem Teil der Substratoberfläche hergestellt wird durch:
- Bereitstellen einer Vorrichtung mit einer Prozesskammer (5);
- Platzieren eines Substrats (1) in die Prozesskammer (5);
- Aufrechterhalten des Substrats (1) bei einer bestimmten Substratbehandlungstemperatur, die geeignet ist, um die Schicht zu herzustellen;
- Erzeugen eines Plasmas (P);
- Inberührungbringen von mindestens einem Teil des Plasmas (P) mit dem Teil der Substratoberfläche;
- Zuführen von mindestens einem Vorläufer, geeignet für die SiOₓ-Herstellung zu dem Teil des Plasmas (P);
- Herstellen der Schicht;
wobei, nachdem die mindestens eine Schicht hergestellt wurde, die Schicht einer Temperbehandlung zum Tempern der Schicht ausgesetzt wird;
**dadurch gekennzeichnet, dass**:
der Schritt der Bereitstellung einer Vorrichtung durch Bereitstellen einer Vorrichtung mit einer Prozesskammer (5), auf welcher mindestens eine Plasmakaskadenquelle (3) bereitgestellt ist, erfolgt, wobei in jeder Plasmakaskadenquelle eine Gleichstromspannung zum Erzeugen des Plasmas verwendet wird, die Vorrichtung ferner mit einem Injektor (6) versehen ist, der konzipiert ist, um ein oder mehrere Behandlungsfluide dem Plasma (P) nahe der Plasmaquelle (3) zuzuführen;
- der Schritt des Platzierens des Substrats ausgeführt wird, indem das Substrat (1) gegenüber einer Ausflussöffnung (4) der Plasmakaskadenquelle (3) in die Prozesskammer (5) platziert wird;
der Schritt des Erzeugens eines Plasmas (P) mithilfe der mindestens einen Plasmakaskadenquelle (3), angebracht auf der Prozesskammer (5) in einem bestimmten Abstand (L) von der Substratoberfläche, ausgeführt wird;
wobei mindestens ein Teil des von jeder Quelle (3) erzeugten Plasmas (P) mit dem Teil der Substratoberfläche in Berührung gebracht wird;
wobei der Druck in der Prozesskammer (5) auf einem Druck unter 5000 Pa gehalten wird, wobei der Druck in der Prozesskammer niedriger ist als der Druck in einer vorderen Kammer (11) der Quelle, sodass ein Teil des erzeugten Plasmas (P) so expandiert, dass es sich von einer Ausflussöffnung (4) der Quelle (3) in die Prozesskammer (5) erstreckt und die Oberfläche des Substrats (2) berührt,
wobei die Temperbehandlung das Zuführen von H₂ oder eines Gemischs aus H₂ und eines Inertgases wie N₂ oder Ar zu einem Plasma umfasst.

3. Verfahren nach Anspruch 1 oder 2, wobei die Temperbehandlung eine Temperaturbehandlung in einer Gasumgebung umfasst und die Temperaturbehandlung das Aufrechterhalten der SiOₓ-Schicht bei einer Behandlungstemperatur von 550°C-650°C, beispielsweise 600°C, umfasst.

4. Verfahren nach Anspruch 3, wobei die Behandlungstemperatur im Bereich von 500°C-700°C, insbesondere im Bereich von 550°C-650°C, zum Beispiel 600°C, liegt.

5. Verfahren nach Anspruch 3 oder 4, wobei die Temperaturbehandlung weniger als 20 Minuten dauert.

6. Verfahren nach einem der Ansprüche 3-5, wobei während der Temperaturbehandlung ein Gasfluss dem Substrat (1) zugeführt wird oder mindestens eine Schicht auf dem Substrat (1) hergestellt wird, um die Gasumgebung bereitzustellen.

7. Verfahren nach einem der Ansprüche 3-6, wobei die Gasumgebung ein Gemisch aus Stickstoffgas und Wasserstoffgas umfasst.

8. Verfahren nach Anspruch 7, wobei das Verhältnis von Stickstoff:Wasserstoff in dem Gemisch im Bereich von 75:25 bis 99:1, insbesondere im Bereich von 85:15 bis 95:5 liegt und beispielsweise 90:10 beträgt.

9. Verfahren nach einem der Ansprüche 3-6, wobei die Gasumgebung Wasserstoffgas umfasst, durch Zuführen eines Wasserstoffgasflusses zu dem Substrat und/oder der mindestens einen auf dem Substrat hergestellten Schicht.

10. Verfahren nach einem der vorhergehenden Ansprüche, wobei das Verfahren das Auswählen von mindestens einem zur SiOₓ-Herstellung geeigneten Vorläufer aus der Gruppe, bestehend aus:
- SiH₄;
- O₂;
- NO₂;
- CH₃SiH₃ (1MS);
- 2(CH₃)SiH₂ (2MS);
- 3(CH₃)SiH (3MS);
- Siloxanen
- Hexamethylsiloxan;
- Octamethyltrisiloxan;
-Bis(trimethylsiloxy)methylsilan;
- Octamethyltetrasiloxan (D4); und
- Tetraethylorthosilicat (TEOS)
umfasst.

11. Verfahren nach einem der vorhergehenden Ansprüche, wobei das Substrat (1) inhärent eine relativ niedrige Resistivität von weniger als 10 Ωcm, insbesondere eine Resistivität von 2 Ωcm oder niedriger, aufweist.

12. Verfahren nach einem der vorhergehenden Ansprüche, **dadurch gekennzeichnet, dass** die SiOₓ-Schicht mit einer Zuwachsrate im Bereich von 1-15 nm/s auf dem Substrat abgesetzt wird.

13. Verfahren nach einem der vorhergehenden Ansprüche, **dadurch gekennzeichnet, dass** die Behandlungstemperatur des Substrats, mindestens während der Herstellung von SiOₓ, im Bereich von 250-550°C, insbesondere im Bereich von 380-420°C, ist.

14. Verfahren nach einem der vorhergehenden Ansprüche, **dadurch gekennzeichnet, dass** die Dicke der SiOx-Schicht, hergestellt auf dem Substrat (1) mithilfe des Plasmabehandlungsprozesses, im Bereich von 10-1.000 nm ist.

15. Verfahren nach einem der vorhergehenden Ansprüche, wobei die mindestens eine Schicht ferner mit mindestens einer SiNₓ-Schicht versehen ist, wobei die SiNₓ-Schicht beispielsweise auf der SiOₓ-Schicht hergestellt wird, beispielsweise zum Zuführen von Wasserstoff zu der abgesetzten SiOₓ-Schicht, zu dem Zweck, das Substrat zu passivieren.

16. Verfahren nach Anspruch 15, wobei die SiOₓ-Schicht und die SiNₓ-Schicht nacheinander durch dieselbe Vorrichtung auf dem Substrat (1) bereitgestellt werden.

17. Verfahren nach Anspruch 15 oder 16, wobei die Dicke der SiNₓ-Schicht im Bereich von 25 bis 100 nm liegt und insbesondere 80 nm beträgt.

18. Verfahren nach einem der vorhergehenden Ansprüche, wobei das Plasma mit O₂ als Vorläufer bereitgestellt wird, sodass die Substratoberfläche in SiOₓ verändert wird, um die SiOₓ-Schicht herzustellen.

19. Verfahren nach Anspruch 1, wobei die Temperbehandlung das Zuführen von H₂ oder eines Gemischs aus H₂ und eines Inertgases, beispielsweise N₂ oder Ar, zu dem Plasma umfasst.

20. Verfahren nach einem der vorhergehenden Ansprüche, wobei der expandierende Plasmateil eine Überschallgeschwindigkeit erreicht.

## Revendications

1. Procédé de passivation d'une partie au moins de la surface d'un substrat semi-conducteur, dans lequel au moins une couche comportant au moins une couche de SiOₓ est formée sur ladite partie de la surface du substrat en
- dotant un appareil d'une chambre destinée au procédé (5) ;
- plaçant un substrat (1) dans la chambre de procédé (5);
- maintenant le substrat (1) à une température spécifique de traitement de substrat appropriée pour réaliser ladite couche ;
- générant un plasma (P) ;
- mettant en contact une partie au moins du plasma (P) avec ladite partie de la surface du substrat ;
- fournissant au moins un précurseur approprié pour la formation de SiOₓ à ladite partie du plasma (P) ;
- réalisant ladite couche ;
dans lequel après que ladite au moins une couche a été réalisée, la couche est soumise à un traitement thermique dans un environnement gazeux en vue d'un recuit de la couche,
dans lequel le traitement thermique comprend particulièrement un traitement de recuit au gaz d'élaboration ;
le procédé étant **caractérisé en ce que** :
l'étape consistant à fournir un appareil est exécutée en fournissant un appareil doté d'une chambre destinée au procédé (5) sur laquelle au moins une source de plasma en cascade (3) est prévue, dans lequel, dans chaque source de plasma en cascade, un courant CC est utilisé pour générer le plasma, l'appareil étant, de plus, doté d'un injecteur (6) conçu pour introduire un ou plusieurs fluide(s) de traitement dans le plasma (P) à proximité de la source de plasma (3) ;
- l'étape consistant à placer le substrat est réalisée en plaçant le substrat (1) de façon opposée à une ouverture d'écoulement (4) de la source de plasma en cascade (3) dans la chambre destinée au procédé (5) ;
l'étape consistant à générer un plasma (P) est réalisée au moyen d'au moins une source de plasma en cascade (3) montée sur la chambre destinée au procédé (5) à une distance spécifique (L) de la surface du substrat ;
dans lequel au moins une partie du plasma (P) générée par chaque source (3) est mise en contact avec ladite partie de la surface de substrat ;
dans lequel la pression exercée dans la chambre destinée au procédé (5) est maintenue à une pression inférieure à 5000Pa, dans lequel la pression de la chambre destinée au procédé est inférieure à la pression exercée dans une chambre avant (11) de la source, de sorte qu'une partie du plasma généré (P) se propage de telle façon qu'il s'étende à partir de l'ouverture d'écoulement (4) de la source (3) dans la chambre destinée au procédé (5) et se trouve en contact avec la surface du substrat (1).

2. Procédé de passivation d'au moins une partie de la surface d'un substrat semi-conducteur, dans lequel au moins une couche comportant au moins une couche de SiOₓ est réalisée sur ladite partie de la surface du substrat en :
- dotant un appareil d'une chambre destinée au procédé (5) ;
- plaçant un substrat (1) dans la chambre destinée au procédé (5);
- maintenant le substrat (1) à une température spécifique de traitement du substrat appropriée pour réaliser ladite couche ;
- générant un plasma (P) ;
- mettant en contact une partie au moins du plasma (P) avec ladite partie de la surface du substrat ;
- fournissant au moins un précurseur approprié pour la formation de SiOₓ sur ladite partie du plasma (P) ;
- réalisant ladite couche ;
dans lequel après qu'une couche au moins a été réalisée, la couche est soumise à un traitement de recuit en vue de recuire la couche ;
le procédé étant **caractérisé en ce que** :
l'étape consistant à fournir un appareil est exécutée en fournissant un appareil doté d'une chambre destinée au procédé (5) sur laquelle au moins une source de plasma en cascade (3) est prévue, dans lequel dans chaque source de plasma en cascade, un courant CC est utilisé pour générer le plasma, l'appareil étant, de plus, doté d'un injecteur (6) conçu pour introduire un ou plusieurs fluide(s) de traitement dans le plasma (P) à proximité de la source de plasma (3) ;
- l'étape de placement du substrat est réalisée en plaçant le substrat (1) de façon opposée à une ouverture d'écoulement (4) de la source de plasma en cascade (3) dans la chambre destinée au procédé (5) ;
l'étape consistant à générer un plasma (P) est réalisée au moyen de la, au moins une, source de plasma en cascade (3) montée sur la chambre destinée au procédé (5) à une distance spécifique (L) de la surface du substrat ;
dans lequel une partie au moins du plasma (P) généré par chaque source (3) est mise en contact avec ladite partie de la surface du substrat ;
dans lequel la pression de la chambre destinée au procédé (5) est maintenue à une pression inférieure à 5000 Pa, dans lequel la pression de la chambre destinée au procédé est inférieure à la pression exercée dans une chambre avant (11) de la source, de sorte qu'une partie du plasma généré (P) se propage d'une façon telle qu'il s'étende à partir de l'ouverture d'écoulement (4) de la source (3) dans la chambre destinée au procédé (5) et se trouve en contact avec la surface du substrat (1),
dans lequel le traitement de recuit comprend de fournir au plasma H₂ ou un mélange de H₂ et d'un gaz inerte tel que N₂ ou Aᵣ.

3. Procédé selon la revendication 1 ou 2, dans lequel le traitement de recuit comprend un traitement thermique dans un environnement gazeux, le traitement thermique incluant de maintenir la couche de SiOₓ à une température de traitement se situant dans la plage de 250°C à 1000°C.

4. Procédé selon la revendication 3, dans lequel ladite température de traitement se situe dans la plage de 500°C à 700°C, plus particulièrement dans la plage de 550°C à 650°C, par exemple 600°C.

5. Procédé selon la revendication 3 ou 4, dans lequel ledit traitement thermique dure moins de 20 min.

6. Procédé selon l'une quelconque des revendications 3 à 5 dans lequel, pendant ledit traitement thermique, un flux de gaz est fourni au dit substrat (1) ou à la au moins une couche réalisée sur le substrat (1) pour fournir ledit environnement gazeux.

7. Procédé selon l'une quelconque des revendications 3 à 6, dans lequel ledit environnement gazeux comporte un mélange d'azote gazeux et d'hydrogène gazeux.

8. Procédé selon la revendication 7, dans lequel le rapport azote/hydrogène dudit mélange se situe dans la plage de 75:25 à 99:1, en particulier dans la plage de 85:15 à 95:5, et il est , par exemple, de 90:10.

9. Procédé selon l'une quelconque des revendications 3 à 6, dans lequel ledit environnement gazeux comprend de l'hydrogène gazeux, en fournissant un flux d'hydrogène gazeux sur le substrat et/ou à la au moins une couche réalisée sur le substrat.

10. Procédé selon l'une quelconque des revendications précédentes, dans lequel le procédé comporte de sélectionner au moins un précurseur, approprié pour la formation de SiOₓ, provenant du groupe constitué de :
- SiH₄ ;
- O₂ ;
- NO₂ ;
- CH₃SiH₃ (1MS) ;
- 2(CH₃)SiH₂(2MS) ;
- 3(CH₃)SiH(3MS) ;
- siloxanes ;
- hexaméthylsiloxane ;
- octaméthyltrisiloxane ;
- bis(triméthylsiloxy)méthylsilane ;
- octaméthyltétrasiloxane (D4) ; et
- tétraéthyl orthosilicate (TEOS).

11. Procédé selon l'une quelconque des revendications précédentes, dans lequel le substrat (1) présente, de façon inhérente, une résistivité relativement faible, inférieure à 10 Ωcm, en particulier, une résistivité de 2 Ωcm ou moins.

12. Procédé selon l'une quelconque des revendications précédentes, **caractérisé en ce que** la couche de SiOₓ est déposée sur le substrat (1) avec une vitesse de croissance qui se situe dans la plage de 1 à 15 nm/s.

13. Procédé selon l'une quelconque des revendications précédentes, **caractérisé en ce que** ladite température de traitement du substrat se situe, au moins pendant la réalisation de SiOₓ, dans la plage de 250 à 550°C, plus particulièrement dans la plage de 380 à 420°C.

14. Procédé selon l'une quelconque des revendications précédentes, **caractérisé en ce que** l'épaisseur de la couche de SiOₓ formée sur le substrat (1) au moyen du procédé de traitement par plasma se situe dans la plage de 10 à 1000 nm.

15. Procédé selon l'une quelconque des revendications précédentes, dans lequel au moins une couche est dotée, de plus, d'au moins une couche de SiNₓ, dans lequel la couche de SiNₓ est, par exemple, réalisée sur ladite couche de SiOₓ, par exemple, en vue de fournir de l'hydrogène à la couche de SiOₓ déposée dans le but de passiver le substrat.

16. Procédé selon la revendication 15, dans lequel lesdites couches de SiOₓ et de SiNₓ sont successivement fournies sur le substrat (1) par le même appareil.

17. Procédé selon la revendication 15 ou 16, dans lequel l'épaisseur de ladite couche de SiNₓ se situe dans la plage de 25 à 100 nm et est, en particulier, de 80 nm.

18. Procédé selon l'une quelconque des revendications précédentes, dans lequel le plasma est fourni avec de l'O₂ comme précurseur, de telle sorte que ladite surface de substrat est transformée en SiOₓ afin de réaliser ladite couche de SiOₓ.

19. Procédé selon la revendication 1, dans lequel le traitement de recuit comprend de fournir du H₂ ou un mélange de H₂ et d'un gaz inerte, par exemple N₂ ou Ar, au dit plasma.

20. Procédé selon l'une quelconque des revendications précédentes, dans lequel la partie de plasma qui se propage atteint une vitesse supersonique.
